# EUROPÄISCHE PATENTSCHRIFT

(11) **EP 3 791 429 B1**
(45) Veröffentlichungstag und Bekanntmachung des Hinweises auf die Patenterteilung: **10.08.2022**
(21) Anmeldenummer: 19723504.7
(22) Anmeldetag: 02.05.2019
(51) Int. Cl.: H01L 31/054

(54) **SOLARGENERATOR**
SOLAR GENERATOR
GÉNÉRATEUR SOLAIRE

(30) Priorität: 07.05.2018 DE 102018110948
(43) Veröffentlichungstag der Anmeldung: 17.03.2021
(73) Patentinhaber: Asiri, Ali, Jeddah, 21534 (SA); Alsoma, Ibrahim, Jeddah, 21534 (SA)
(72) Erfinder: Asiri, Ali, Jeddah, 21534 (SA); Alsoma, Ibrahim, Jeddah, 21534 (SA)
(74) Vertreter: Geskes, Christoph
(86) Internationale Anmeldenummer: PCT/IB2019/053597
(87) Internationale Veröffentlichungsnummer: WO 2019/215549

(56) Entgegenhaltungen:
- EP-A1- 2 136 409
- EP-A2- 2 234 178
- DE-A1- 19 735 281
- DE-U1-202007 002 898
- US-A- 5 089 055
- US-A- 5 575 860
- US-A1- 2010 108 142

## Beschreibung

Die Erfindung betrifft einen Solargenerator. Die Erfindung betrifft auch die Verwendung eines Solargenerators zur Erzeugung elektrischer Energie aus Sonnenlicht.

Die Nachfrage nach erneuerbaren Energien, insbesondere durch Solarenergie ist hoch. Nachteilig bei bekannten Solargeneratoren mit Solarmodulen ist, dass die Solarmodule meist großflächig angeordnet und zur Sonne ausgerichtet werden müssen. Dies ist aufwendig und wird auch teilweise als unschön empfunden. In dichtbebauten Gebieten ist eine großflächige Anordnung von Solarmodulen auch nur begrenzt möglich. Je nach Witterung müssen die Solarmodule regelmäßig gewartet und gesäubert werden. Dies kann sehr aufwendig sein, insbesondere bei Montagen der Module auf einem Hausdach.

DE 197 35 281 A1 offenbart eine Einrichtung zur Erzeugung von Energie durch Sonnen- bzw. Sonnenlichtstrahlung mit mindestens einem Glaskörper, der im Wesentlichen eine auf die Spitze gestellte Trichterform aufweist, wobei die Spitze in ein Ende eines mindestens einadrigen, vorzugsweise Glasfaserkabels mündet, welches mit zumindest einem Solarzellenmodul oder einen flüssigen Wärmeträger enthaltenen Behälter verbunden ist.

US 5,575,860 offenbart eine energieerzeugende Anordnung, umfassend eine Schichtung von abwechselnden photovoltaischen Elementen und lichtverteilenden Elementen, die so positioniert sind, dass Licht über die Oberflächenbereiche der photovoltaischen Elemente verteilt wird, und Mittel zum Entnehmen von Strom aus den photovoltaischen Elementen, wobei die Schichtung mindestens eine Seite aufweist, an der die Kanten der lichtverteilenden Elemente Sonnenenergie erhalten zur Verteilung auf den photovoiltaischen Elementen, wobei die Schichtung zu einem kompakten Aufbau zusammenklappbar und zu einer erweiterten Konfiguration erweiterbar ist.

Es ist die Aufgabe der Erfindung, einen verbesserten Solargenerator bereitzustellen, der besonders kompakt ausgebildet ist und besonders einfach gewartet werden kann.

Die Aufgabe wird gelöst durch einen erfindungsgemäßen Solargenerator wie nachfolgend beschrieben.

Der erfindungsgemäße Solargenerator weist eine Anzahl von Solarmodulen und eine Anzahl von Lichtwellenleitern auf, wobei jedes Solarmodul mindestens eine Solarzelle und mindestens eine Oberfläche zur Aufnahme von Sonnenlicht aufweist, wobei jeder Lichtwellenleiter mindestens ein erstes Ende mit einer ersten Stirnseite zur Aufnahme von Sonnenlicht und mindestens ein zweites Ende mit einer zweiten Stirnseite zur Abgabe von Sonnenlicht aufweist, wobei an jeder Oberfläche der Anzahl von Solarmodulen mindestens eine zweite Stirnseite der Anzahl von Lichtwellenleitern derart vor oder an der jeweiligen Oberfläche angeordnet ist, dass durch die mindestens eine zweite Stirnseite abgegebenes Sonnenlicht zumindest teilweise auf die jeweilige Oberfläche trifft, wobei der Solargenerator zumindest eine perforierte Abdeckscheibe mit mindestens einer Durchgangsöffnung umfasst und mindestens ein zweites Ende der Anzahl von Lichtwellenleitern zumindest teilweise in der Durchgangsöffnung angeordnet ist, wobei an der Abdeckscheibe des Solargenerators mindestens ein Reflektor an einer einem Solarmodul zugewandten Oberfläche der Abdeckscheibe angeordnet ist und mehrere Solarmodule als mindestens eine Stapelung angeordnet sind.

Der erfindungsgemäße Solargenerator hat den Vorteil, dass die Solarmodule nicht flächig zur Sonne ausgerichtet werden müssen. Die Solarmodule können beliebig zueinander angeordnet werden, beispielsweise als Stapelung. Die Solarmodule können auch in einem Gehäuse beziehungsweise in einem Innenraum eines Gebäudes angeordnet werden. Dort sind diese vor Witterung geschützt. Die Solarmodule können beispielsweise in einem Gebäudekeller angeordnet sein. Hierdurch müssen die Solarmodule weniger intensiv gewartet werden. Die Sonnenlichteinspeisung erfolgt erfindungsgemäß durch die Lichtwellenleiter, wobei durch die erfindungsgemäße Anordnung der Lichtwellenleiter, das Sonnenlicht besonders effizient an die Solarmodule abgegeben wird.

Unter einer Solarzelle im Sinne der Erfindung wird ein Bauteil verstanden, das dazu ausgebildet ist, um Sonnenlicht direkt in elektrische Energie umzuwandeln. Hierdurch kann dann Strom erzeugt werden. Mindestens eine Solarzelle kann beispielsweise als Farbstoff-Solarzelle, organische Solarzelle, oder Halbleitersolarzelle ausgebildet sein. Mindestens eine Solarzelle kann besonders bevorzugt Silizium umfassen. Diese Solarzelle kann beispielsweise als Dickschicht- oder Dünnschicht-Siliziumzelle ausgebildet sein.

Vorzugsweise umfasst ein Solarmodul eine Vielzahl von Solarzellen. Die Solarzellen sind vorzugsweise in Reihe geschaltet. Die Solarzellen können flächig als Solarpaneele in den Solarmodulen vorliegen. Das Solarmodul kann für die Solarzellen eine Kapselung aufweisen.

Mindestens ein Lichtwellenleiter ist vorzugsweise als Glasfaserkabel ausgebildet. Mindestens ein Lichtwellenleiter weist bevorzugt einen Durchmesser vom 0,5 mm bis 4 mm auf. Mindestens ein Lichtwellenleiter weist besonders bevorzugt einen Durchmesser von 2 mm auf. Vorzugsweise weisen alle Lichtwellenleiter des erfindungsgemäßen Solargenerators den gleichen Durchmesser auf.

Zum Schutz vor Witterung kann zumindest ein Lichtwellenleiter eine Ummantelung aufweisen. Besonders bevorzugt weist eine Anzahl von Lichtwellenleiter, die in einem Bündel angeordnet sind, zumindest abschnittsweise eine gemeinsame Ummantelung auf.

Die mindestens eine zweite Stirnseite ist vorzugsweise im Wesentlichen parallel zur jeweiligen Oberfläche des Solarmoduls angeordnet, damit die Stirnseite direkt, beziehungsweise frontal zur Oberfläche ausgerichtet ist, um besonders effektiv Sonnenlicht an diese abzugeben. Denn das abgegebene Sonnenlicht trifft derart direkt und im Wesentlichen frontal auf die Oberfläche auf.

Die mindestens eine zweite Stirnseite ist im Wesentlichen orthogonal zu einer Längsmittelachse des jeweiligen zweiten Endes des Lichtwellenleiters ausgebildet. Alternativ kann die mindestens eine zweite Stirnseite in einem schrägen Winkel zu einer Längsmittelachse des jeweiligen zweiten Endes des Lichtwellenleiters ausgebildet sein, um die Oberfläche der zweiten Stirnseite zu erhöhen und um den Austrittswinkel des abgegebenen Sonnenlichts festzulegen.

Um eine einfache Herstellung zu realisieren, sind bevorzugt mindestens eine erste Stirnseite, und/oder mindestens eine zweite Stirnseite der Anzahl von Lichtwellenleitern plan ausgebildet.

Um einen besonders weiten Eintrittswinkel, beziehungsweise um eine besonders weite Streuung des abgegebenen Sonnenlichts realisieren zu können, sind vorzugsweise mindestens eine erste Stirnseite und/oder mindestens eine zweite Stirnseite der Anzahl von Lichtwellenleitern konvex ausgebildet. Die mindestens eine erste Stirnseite und/oder mindestens eine zweite Stirnseite können beispielsweise halbkugelförmig ausgebildet sein.

Der Solargenerator umfasst erfindungsgemäß mindestens einen Reflektor, um Sonnenlicht zu einer Oberfläche zur Aufnahme von Sonnenlicht eines Solarmoduls zu leiten. Auf diese Weise kann eine ungewollte Absorption von Sonnenlicht durch andere Bauteile als der Oberfläche eines Solarmoduls vermieden werden.

Der Solargenerator umfasst erfindungsgemäß eine perforierte Abdeckscheibe mit mindestens einer Durchgangsöffnung, wobei mindestens ein zweites Ende der Anzahl von Lichtwellenleitern zumindest teilweise in der Durchgangsöffnung angeordnet ist. Die Durchgangsöffnung ist beispielsweise als Bohrung ausgebildet.

Die Abdeckscheibe weist vorzugsweise eine Vielzahl von Durchgangsöffnung auf. Um eine gleichmäßige Beleuchtung der Oberfläche eines Solarmoduls zu realisieren, sind die Durchgangsöffnungen vorzugsweise in einem gleichmäßigen Raster auf der Abdeckscheibe angeordnet.

Die Abdeckscheibe kann eine Durchgangsöffnung aufweisen, die orthogonal zu einer Oberfläche eines Solarmoduls angeordnet ist, um das jeweilige, in der Durchgangsöffnung angeordnete zweite Ende eines Lichtwellenleiters orthogonal zur Oberfläche auszurichten.

Die Abdeckscheibe kann eine Durchgangsöffnung aufweisen, die schräg zu einer Oberfläche eines Solarmoduls angeordnet ist, um das jeweilige in der Durchgangsöffnung angeordnete zweite Ende eines Lichtwellenleiters zur Oberfläche in einem schrägen Winkel auszurichten.

Dies kann beispielsweise vorgesehen sein, um Ecken und/oder Ränder der Oberfläche eines Solarmoduls auszuleuchten.

Die Abdeckscheibe kann auch als Träger für zumindest ein Solarmodul ausgebildet sein. Beispielsweise kann die Abdeckscheibe an einer Rückseite eines Solarmoduls angeordnet sein. Das beziehungsweise die in der Abdeckscheibe angeordneten zweiten Enden können dann zu einer Oberfläche eines benachbarten Solarmoduls ausgerichtet sein. Dieses benachbarte Solarmodul kann wiederum auch eine Abdeckscheibe als Träger aufweisen, welche an der Rückseite des Solarmoduls angeordnet ist. Das beziehungsweise die in der Abdeckscheibe angeordneten zweiten Enden können dann wiederum zu einer Oberfläche eines weiteren benachbarten Solarmoduls ausgerichtet sein und so weiter. Derart kann eine Stapelung von mehreren Solarmodulen übereinander realisiert werden. Abdeckscheiben können wie Regalböden zur Anordnung von mehreren Solarmodulen übereinander verwendet werden.

Alternativ kann die Abdeckscheibe auch über beziehungsweise an der Oberfläche eines Solarmoduls angeordnet sein. Das beziehungsweise die in der Abdeckscheibe angeordneten zweiten Enden können dann zu der Oberfläche des Solarmoduls ausgerichtet sein. Diese Anordnung kann in einer Stapelung von Solarmodulen mehrfach übereinander angeordnet werden. Die Abdeckscheiben können wie Regalböden verwendet werden, an denen die Solarmodule angehängt sind.

Auch eine Stapelung nebeneinander benachbarter Solarmodule ist denkbar. Hierzu werden die vorbeschriebenen Anordnungen auf die Seite gelegt beziehungsweise um 90° gedreht. Dadurch, dass die Abdeckscheibe sowohl als Führung beziehungsweise Halterung mindestens ein zweites Endes und als Träger beziehungsweise Halterung für mindestens ein Solarmodul fungiert, ist eine besonders einfache und kompakte Bauweise, insbesondere durch Stapelung wie vorbeschriebenen, realisierbar.

Die Abdeckscheibe kann zumindest einen Abstandshalter umfassen, um zwischen der Abdeckscheibe und dem jeweiligen Solarmodul einen Spalt bereitzustellen. In dem Spalt kann beispielsweise ein Lichtwellenleiter durchgeführt werden.

An der Abdeckscheibe des Solargenerators ist bevorzugt mindestens ein Reflektor angeordnet. Die Abdeckscheibe kann beispielsweise eine reflektierende Folie, Beschichtung und/oder Anstrich aufweisen. Der Reflektor kann besonders bevorzugt eine spiegelnde Oberfläche umfassen. Der Reflektor kann ein Metall umfassen.

Zum Schutz vor Witterung weist der Solargenerator vorzugsweise mindestens eine Abdeckung für mindestens ein erstes Ende der Anzahl von Lichtwellenleitern auf. Die Abdeckung ist besonders bevorzugt zumindest teilweise lichtdurchlässig ausgebildet. Die Abdeckung kann beispielweise zumindest teilweise aus Glas und/oder Kunststoff ausgebildet sein.

Zum Schutz vor Witterung kann der Solargenerator mindestens ein Gehäuse umfassen. Das Gehäuse kann vorzugsweise einen ersten Gehäuseteil für zumindest eine erste Stirnseite eines Lichtwellenleiters und einen zweiten Gehäuseteil für mindestens eine zweite Stirnseite und mindestens ein Solarmodul umfassen. Die Gehäuseteile können separat ausgebildet sein. Das Gehäuse kann eine Kühlung und/oder Lüftung umfassen. Das Gehäuse kann zumindest einen Reflektor umfassen. Der Reflektor kann wie vorbeschrieben als Folie, Farbe beziehungsweise Anstrich und/oder Bedampfung an einer Innenwandung des Gehäuses ausgebildet sein. Die Abdeckung kann als Deckelteil des Gehäuses, insbesondere des ersten Gehäuseteils ausgebildet sein.

Zur Anordnung mindestens eines ersten Endes kann der Solargenerator zumindest eine Halterung umfassen. Die Halterung kann auch als perforierte Abdeckscheibe mit mindestens einer Durchgangsöffnung und weiter bevorzugt mit einer Vielzahl von Durchgangsöffnungen ausgebildet sein. In der Durchgangsöffnung kann zumindest teilweise ein erstes Ende eines Lichtwellenleiters angeordnet sein, das zur Abdeckung ausgerichtet ist.

Die Abdeckung kann alternativ oder ergänzend auch zumindest eine Ausnehmung zur Aufnahme einer ersten Stirnseite und eines Teil eines ersten Endes eines Lichtwellenleiters aufweisen. Die Ausnehmung kann als Bohrung ausgebildet sein.

Besonders bevorzugt weist die Abdeckung mindestens eine Linse zur Lichtbündelung auf. Die Linse kann einstückig mit der Abdeckung ausgebildet sein. Beispielsweise kann die Abdeckung eine Wölbung, einen konkaven Abschnitt und/oder eine Kuppel umfassen. Die Linse kann sich bevorzugt über mehrere ersten Enden erstecken.

Die Abdeckung kann mindestens einen Reflektor aufweisen. Der Reflektor kann als eine reflektierende Folie, Beschichtung und/oder Anstrich ausgebildet sein. Der Reflektor kann unterseitig an der Abdeckung angeordnet sein. Der Reflektor kann beabstandet unterseitig an der Abdeckung angeordnet sein. Der Reflektor kann oberseitig an der vorbeschriebenen Halterung ausgebildet sein. Es ist auch denkbar, dass ein Reflektor außenseitig an der Abdeckung beziehungsweise dem Gehäuse angeordnet ist, der Sonnenlicht zur Abdeckung lenkt.

Der Solargenerator umfasst vorzugsweise zumindest ein Mittel zur Ausrichtung mindestens eines ersten Endes der Anzahl von Lichtwellenleitern zur Sonne. Das Mittel kann einen Motor umfassen. Der Motor kann in Wirkverbindung mit einem ersten Ende der Anzahl von Lichtwellenleitern sein.

Der Motor kann in Wirkverbindung mit der vorbeschriebenen Halterung zumindest eines ersten Endes der Anzahl von Lichtwellenleitern sein. Der Motor kann zum Neigen und/oder Drehen der Halterung ausgebildet sein. Alternativ oder ergänzend kann der Solargenerator einen Motor umfassen, der in Wirkverbindung mit einer Abdeckung, einer Linse, einem Gehäuse und/oder einem Reflektor wie vorbeschrieben steht.

Der Solargenerator kann mindestens einen Sensor zur Erfassung des Sonnenstands beziehungsweise der Sonnenposition umfassen. Der Solargenerator kann alternativ oder ergänzend zumindest eine Steuerungseinrichtung umfassen, die den Sonnstand, beispielsweise mittels astronomischer Daten ermittelt. Der Sensor und/oder die Steuerungseinrichtung stehen vorzugsweise in Wirkverbindung mit dem vorbeschriebenen Motor. Mittels des Sensors und/oder der Steuerungseinrichtung kann eine automatisierte Ausrichtung mindestens eines ersten Endes eines Lichtwellenleiters, einer Halterung, einer Abdeckung, eines Gehäuses, einer Linse und/oder eines Reflektors, wie vorbeschrieben, zur Sonne erfolgen.

Bevorzugt sind beim Solargenerator mehrere Lichtwellenleiter zumindest teilweise als mindestens ein Bündel angeordnet, um den Zusammenbau des Solargenerators zu erleichtern. Zum Schutz vor Witterung kann zumindest ein Lichtwellenleiter eine Ummantelung aufweisen. Besonders bevorzugt weist eine Anzahl von Lichtwellenleiter, die in einem Bündel angeordnet sind, zumindest abschnittsweise eine gemeinsame Ummantelung auf.

Für eine besonders kompakte Bauweise weist der Solargenerator erfindungsgemäß mehrere Solarmodule auf, die als mindestens eine Stapelung angeordnet sind.

In der Stapelung sind zumindest zwei Solarmodule derart angeordnet, dass deren Oberflächen zur Sonnenlichtaufnahme voneinander beabstandet sind. Die Solarmodule sind beispielsweise besonders bevorzugt übereinander angeordnet, können aber auch nebeneinander angeordnet sein, indem der Stapel um 90° auf die Seite gekippt ist. Die Solarmodule sind bevorzugt als plane Bauteile ausgebildet und weisen beispielsweise eine viereckige Grundform, beispielsweise in Form eines Rechtecks oder eines Quadrates, auf. Hierdurch ist eine einfache Stapelung erzielbar. Bevorzugt ist einem jeden Solarmodul in einer Stapelung eine ebenfalls plane Abdeckscheibe zugeordnet, die weiter bevorzugt im Wesentlichen die gleiche Grundform aufweist wie ein Solarmodul. Die Abdeckscheibe kann dabei als Träger für ein Solarmodul fungieren oder aber über oder an einem Solarmodul angeordnet sein, bevorzugt beabstandet, um eine Führung der Vielzahl von Lichtwellenleitern zu ermöglichen. Die Lichtwellenleiter können aber auch in der Abdeckscheibe selbst geführt oder in diese eingelebt sein, beispielsweise durch Bohrungen oder Ausnehmungen in Kanalform. Die Abdeckscheibe weist bevorzugt eine Vielzahl von Durchgangsöffnungen auf, ist also perforiert. In die Durchgangsöffnungen sind in dieser bevorzugten Ausführungsform einer Stapelung die zweiten Enden der Lichtwellenleiter geführt. Die Durchgangsöffnungen sind bevorzugt orthogonal zu den Oberflächen der Abdeckscheibe beziehungsweise der Solarmodule ausgebildet, können aber auch in einem Winkel hierzu, bevorzugt bis zu 45°, ausgebildet sein. Die zweiten Stirnseiten der zweiten Enden der Lichtwellenleiter sind bevorzugt ebenfalls orthogonal zu den Oberflächen der Abdeckscheibe beziehungsweise der Solarmodule ausgebildet. Auf einer einem Solarmodul zugewandten Oberfläche weisen die Abdeckscheiben in diese bevorzugten Ausführungsform einen Reflektor, beispielsweise in Form eines reflektierenden Anstrichs oder einer solchen Beschichtung oder einer reflektierenden Folie auf, bevorzugt auf einer gesamten Oberfläche einer Abdeckscheibe, wodurch vorteilhafterweise in der Stapelung die Effektivität des Solargenerators erhöht wird. Eine abwechselnde Stapelung von Solarmodulen mit Abdeckscheiben mit einer Vielzahl von Durchgangsöffnungen für zweite Enden von Lichtwellenleitern und einem Reflektor an einer einem Solarmodul zugewandten Oberfläche einer Abdeckscheibe ist besonders bevorzugt im Sinne der vorliegenden Erfindung und ermöglicht eine räumlich kompakte Ausbildung des Solargenerators mit hoher Lichtausbeute und damit effizienter Stromerzeugung. Eine solche Stapelung oder mehrere solcher Stapelungen sind bevorzugt mit mindestens einer Abdeckung, bevorzugt mit einer Linse, wie vorstehend beschrieben, über die ersten Enden der Vielzahl von Lichtwellenleitern verbunden. Die mindestens eine Abdeckung ist dabei bevorzugt auf einem Dach eines Gebäudes, insbesondere eines Hochhauses, angeordnet, und die mindestens eine Stapelung in einem Inneren des Gebäudes, bevorzugt dachnah angeordnet. Hierdurch kann eine effektive Stromerzeugung in Gebäuden für Kühlung, Heizung oder Wasseraufbereitung erzielt werden. Bevorzugt sind bei einer solchen abwechselnden Stapelung aus Solarmodulen und Abdeckscheiben in planer Weise mindestens drei, vier, fünf, sechs oder mehr Solarmodule und Abdeckscheiben vorgesehen, noch weiter bevorzugt mehr als 10, 15 oder mehr als 20 Solarmodule und Abdeckscheiben.

Der Solargenerator kann mindestens eine Batterie beziehungsweise Pufferbatterie zur Speicherung der erzeugten elektrischen Energie aufweisen. Die Batterie kann beispielsweise als Blei- oder Lithium-Ionen-Akkumulator ausgebildet sein. Die Batterie ist bevorzugt zumindest einem Solarmodul beziehungsweise einer Solarzelle nachgeschaltet.

Gemäß einer ersten bevorzugten Ausführungsform weist der Solargenerator ein Solarmodul mit einer Vielzahl von Solarzellen auf, wobei das Solarmodul eine Oberfläche zur Aufnahme von Sonnenlicht aufweist. Von der Oberfläche gelangt das Sonnenlicht zu den Solarzellen zur Erzeugung von elektrischer Energie. Der Solargenerator weist einen Lichtwellenleiter auf. Der Lichtwellenleiter weist ein erstes Ende mit einer ersten Stirnfläche und ein zweites Ende mit einer zweiten Stirnfläche auf. Beide Stirnflächen sind plan ausgebildet. Die erste Stirnfläche ist an einer Abdeckung angeordnet. Die Abdeckung ist als Glasscheibe ausgebildet und umfasst eine Linse. Das von der Sonne ausgestrahlte Sonnenlicht wird von der Linse fokussiert und gelangt über die Abdeckung zur ersten Stirnfläche. Das von der ersten Stirnfläche aufgenommene Sonnenlicht wird durch den Lichtwellenleiter zum zweiten Ende geleitet.

Durch die zweite Stirnfläche wird das Sonnenlicht vom Lichtwellenleiter wieder abgegeben. Das abgegebene Sonnenlicht trifft auf die Oberfläche des Solarmoduls und damit auf die Solarzellen.

Die Stirnseiten sind plan ausgebildet. Die erste Stirnseite ist orthogonal zu einer Längsmittelachse x des zweiten Endes des Lichtwellenleiters ausgebildet. Die zweite Stirnseite ist orthogonal zu einer Längsmittelachse x des zweiten Endes des Lichtwellenleiters ausgebildet. Die erste Stirnfläche ist einer Halterung unterseitig an der Abdeckung angeordnet. Die zweite Stirnseite ist vor der Oberfläche dadurch angeordnet, dass das zweite Ende in einer als perforierte Abdeckscheibe ausgebildeten Halterung angeordnet ist. Das zweite Ende ist in einer Durchgangsöffnung der perforierten Abdeckscheibe aufgenommen, wobei die zweite Stirnseite unterseitig von der Abdeckscheibe in Richtung der Oberfläche weg ragt. Die Durchgangsöffnung ist orthogonal zur Oberfläche ausgerichtet. Die zweite Stirnseite ist parallel zur Oberfläche ausgerichtet. Unterseitig an der perforierten Abdeckscheibe ist ein Reflektor angeordnet. Der Reflektor ist mittels eines reflektierenden Anstrichs hergestellt, der unterseitig an der perforierten Abdeckscheibe aufgetragen wurde. Die Abdeckung, die perforierte Abdeckscheibe und das Solarmodul sind an einem Gehäuse angelagert. Die Abdeckung fungiert als Deckel des Gehäuses. Die vorbeschriebene Ausführungsform eignet sich insbesondere zum Einbau in mobile Vorrichtungen, wie einem Fahrzeug.

Gemäß einer zweiten bevorzugten Ausführungsform weist der Solargenerator eine Vielzahl von Lichtwellenleitern auf. Die Lichtwellenleiter sind im Wesentlichen jeweils wie die Lichtwellenleiter des Solargenerators der ersten bevorzugten Ausführungsform ausgebildet. Die Lichtwellenleiter weisen jeweils ein erstes Ende mit einer ersten Stirnseite auf, die plan ausgebildet ist. Die ersten Stirnseiten sind jeweils orthogonal zu einer Längsmittelachse der ersten Enden ausgebildet. Die ersten Stirnseiten sind unterseitig mittels einer Halterung an einer Abdeckung angeordnet. Die Abdeckung ist als Glasscheibe ausgebildet und weist eine großflächige Linse auf, die sich oberseitig an der Abdeckung über die Stirnseiten erstreckt. Die Abdeckung ist oberseitig als Deckel an einem ersten Gehäuseteil angeordnet. Die zweiten Enden sind in einem zweiten, separaten Gehäuseteil angeordnet. Die beiden Gehäuseteile sind durch die Lichtwellenleiter miteinander verbunden. Die Lichtwellenleiter treten als Bündel aus dem ersten Gehäuseteil aus. Die Lichtwellenleiter weisen eine gemeinsame Ummantelung auf. Die Lichtwellenleiter teilen sich nach Eintritt in das zweite Gehäuseteil zu kleinen Bündeln, je nach Anzahl der im zweiten Gehäuseteil angeordneten Solarmodule, auf. In dem zweiten Gehäuseteil sind beispielsweise drei Solarmodule angeordnet. Die Solarmodule sind jeweils im Wesentlichen wie das Solarmodul gemäß der ersten bevorzugten Ausführungsform ausgebildet. Diese weisen jeweils eine Vielzahl von Solarzellen und oberseitig eine Oberfläche zur Aufnahme von Sonnenlicht auf. Die Solarmodule sind als Stapelung übereinander angeordnet. Über den Oberflächen ist jeweils eine perforierte Abdeckscheibe angeordnet. Den Solarmodulen ist eine Batterie nachgeschaltet. Die perforierten Abdeckscheiben weisen Durchgangsöffnungen auf, die jeweils wie die Durchgangsöffnung der ersten bevorzugten Ausführungsform ausgebildet ist. Die Abdeckscheiben können eine Vielzahl von Durchgangsöffnung aufweisen, je nachdem wie viele Lichtwellenleiter angeordnet werden sollen, mindestens beispielsweise vier Durchgangsöffnungen. Die perforierten Abdeckscheiben weisen jeweils unterseitig einen Reflektor auf, der als Anstrich hergestellt wurde. In den Durchgangsöffnungen ist jeweils ein zweites Ende eines Lichtwellenleiters angeordnet, wobei die zweiten Stirnseiten unterseitig in Richtung der jeweiligen Solarmodule weg ragen. Die Durchgangsöffnungen sind orthogonal zu den Oberflächen der jeweiligen Solarmodule ausgebildet. Die zweiten Stirnseiten sind jeweils orthogonal zu Längsmittelachsen der zweiten Enden ausgebildet. Die zweiten Stirnseiten sind auch jeweils plan ausgebildet und parallel zur Oberfläche des jeweiligen Solarmoduls ausgerichtet. Durch diese Anordnung trifft von den zweiten Stirnseiten abgegebenes Sonnenlicht direkt auf die Oberfläche des jeweiligen Solarmoduls auf. Hierdurch wird eine besonders effiziente Sonnenlichtübertragung auf die Solarmodule ermöglicht. Beim Betrieb des Solargenerators zur Erzeugung elektrischer Energie ist die Abdeckung zur Sonne ausgerichtet. Sonnenlicht gelangt über die Abdeckung zu den ersten Stirnseiten. Das von den ersten Stirnseiten der Lichtwellenleiter aufgenommene Sonnenlicht wird durch die Lichtwellenleitern zu den Solarmodulen geleitet und auf diese verteilt. Das Sonnenlicht wird hierfür durch die zweiten Stirnseiten in Richtung der jeweiligen Oberfläche der Solarmodule abgegeben. In den Solarmodulen wird das Sonnenlicht durch die Solarzellen zu elektrischer Energie umgewandelt, der in die nachgeschaltete Batterie eingespeist wird. Die zweite bevorzugte Ausführungsform eignet sich besonders zur Installation in Gebäude.

Erfindungsgemäß wird ein vorbeschriebener Solargenerator zur Erzeugung elektrischer Energie aus Sonnenlicht verwendet, wobei der Solargenerator eine Vielzahl von Solarmodulen und/oder Lichtwellenleitern umfasst. Bevorzugt ist eine erfindungsgemäße Verwendung bei einer Ausbildung des Solargenerators mit mindestens einer Stapelung, wie vorstehend beschrieben, insbesondere mindestens einer Stapelung von Solarmodulen abwechselnd mit Abdeckscheiben mit Durchgangsöffnungen und Reflektor. Weiter bevorzugt ist eine Verwendung, bei der mindestens eine Abdeckung, insbesondere mit einer Linse, auf einem Dach eines Gebäudes und mindestens eine Stapelung, insbesondere eine wie vorstehend beschriebene, in einem Inneren des Gebäudes, bevorzugt dachnah, angeordnet ist.

Weitere vorteilhafte Ausgestaltungen gehen aus den nachfolgenden Zeichnungen hervor. Gleiche Teile oder Teile mit gleicher Funktion können die gleichen Bezugszeichen aufweisen. Die in den Figuren dargestellten Ausführungsformen sind nicht beschränkend auszulegen. Vielmehr können dort beschriebene Merkmale untereinander und mit den zuvor beschriebenen Merkmalen zu weiteren Ausgestaltungen kombiniert werden. Es zeigen:
- Fig.1:: eine schematische Seitenansicht einer ersten Ausführungsform eines erfindungsgemäßen Solargenerators; und
- Fig. 2:: eine schematische Seitenansicht einer ersten Ausführungsform eines erfindungsgemäßen Solargenerators.

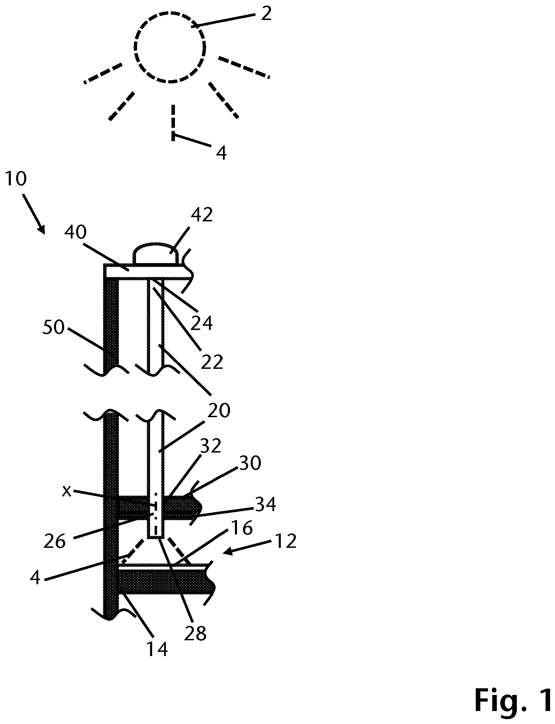

Fig. 1 zeigt, dass der Solargenerator 10 ein Solarmodul 12 eine Vielzahl von Solarzellen 14 und eine Oberfläche 16 zur Aufnahme von Sonnenlicht 4 aufweist. Von der Oberfläche 16 gelangt das Sonnenlicht 4 zu den Solarzellen 14 zur Erzeugung elektrischer Energie. Der Solargenerator 10 weist einen Lichtwellenleiter 20 auf. Der Lichtwellenleiter 20 weist ein erstes Ende 22 mit einer ersten Stirnfläche 24 und ein zweites Ende 26 mit einer zweiten Stirnfläche 28 auf. Beide Stirnflächen 24, 28 sind plan ausgebildet. Die erste Stirnfläche 24 ist an einer Abdeckung 40 angeordnet. Die Abdeckung 40 ist als Glasscheibe ausgebildet und umfasst eine Linse 42. Das von der Sonne 2 ausgestrahlte Sonnenlicht 4 wird von der Linse 42 fokussiert und gelangt über die Abdeckung 40 zur ersten Stirnfläche 24. Das von der ersten Stirnfläche 24 aufgenommene Sonnenlicht 4 wird durch den Lichtwellenleiter 20 zum zweiten Ende 26 geleitet. Durch die zweite Stirnfläche 28 wird das Sonnenlicht 4 vom Lichtwellenleiter 20 wieder abgegeben. Das abgegebene Sonnenlicht 4 trifft auf die Oberfläche 16 des Solarmoduls und damit auf die Solarzellen 14.

Die Stirnseiten 24, 28 sind plan ausgebildet. Die erste Stirnseite 24 ist orthogonal zu einer Längsmittelachse x des zweiten Endes 28 des Lichtwellenleiters 20 ausgebildet. Die zweite Stirnseite 28 ist orthogonal zu einer Längsmittelachse x des zweiten Endes 28 des Lichtwellenleiters 20 ausgebildet. Die erste Stirnfläche 24 ist mittels einer nicht dargestellten Halterung unterseitig an der Abdeckung 40 angeordnet. Die zweite Stirnseite 28 ist vor der Oberfläche 16 dadurch angeordnet, dass das zweite Ende 26 in einer als perforierte Abdeckscheibe 30 ausgebildeten Halterung angeordnet ist. Das zweite Ende 28 ist in einer Durchgangsöffnung 32 der perforierten Abdeckscheibe 30 aufgenommen, wobei die zweite Stirnseite 28 unterseitig von der Abdeckscheibe 30 in Richtung der Oberfläche 16 weg ragt. Die Durchgangsöffnung 32 ist orthogonal zur Oberfläche 16 ausgerichtet. Die zweite Stirnseite 28 ist parallel zur Oberfläche 16 ausgerichtet.

Unterseitig an der perforierten Abdeckscheibe30 ist ein Reflektor 34 angeordnet. Der Reflektor 34 ist mittels eines reflektierenden Anstrichs hergestellt, der unterseitig an der perforierten Abdeckscheibe 30 aufgetragen wurde. Die Abdeckung 40, die perforierte Abdeckscheibe 30 und das Solarmodul 12 sind an einem Gehäuse 50 angelagert. Die Abdeckung 40 fungiert als Deckel des Gehäuses 50.

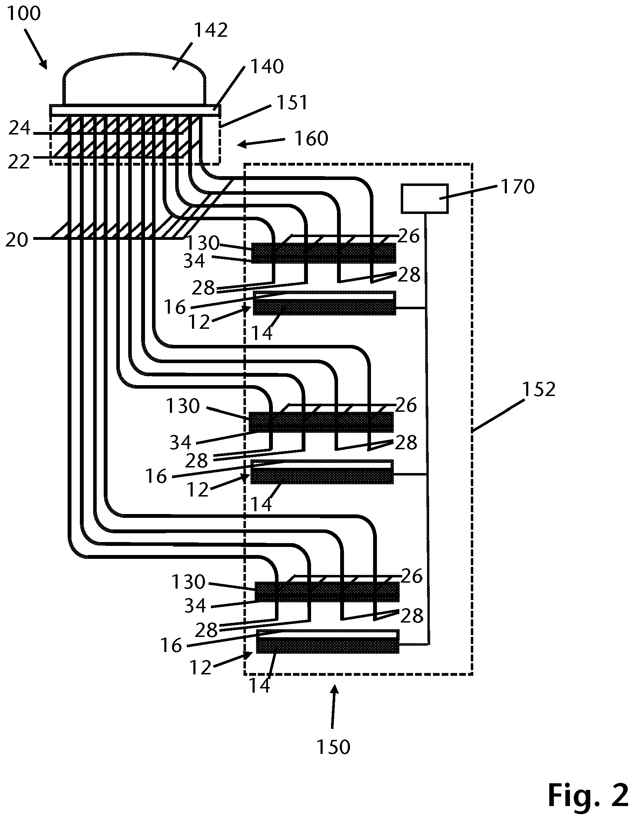

Fig. 2 zeigt, dass die zweite Ausführungsform des Solargenerators 100 eine Vielzahl von Lichtwellenleitern 20 aufweist. Dargestellt sind zwölf Lichtwellenleiter 20. Die Lichtwellenleiter 20 sind im Wesentlichen jeweils wie die Lichtwellenleiter 20 des Solargenerators 10 gemäß Fig. 1 ausgebildet. Die Lichtwellenleiter 20 weisen jeweils ein erstes Ende 22 mit einer ersten Stirnseite 24 auf, die plan ausgebildet ist. Die ersten Stirnseiten 24 sind jeweils orthogonal zu einer nicht gezeigten Längsmittelachse der ersten Enden 22 ausgebildet. Die ersten Stirnseiten 24 sind unterseitig mittels einer nicht dargestellten Halterung an einer Abdeckung 140 angeordnet. Die Abdeckung 140 ist als Glasscheibe ausgebildet und weist eine großflächige Linse 142 auf, die sich oberseitig an der Abdeckung 140 über die Stirnseiten 24 erstreckt. Die Abdeckung 140 ist oberseitig als Deckel an einem ersten Gehäuseteil 151 angeordnet.

Die zweiten Enden 28 sind in einem zweiten Gehäuseteil 152 angeordnet. Die Gehäuseteile 151 und 152 sind durch die Lichtwellenleiter 20 miteinander verbunden. Die Lichtwellenleiter 20 treten als Bündel 160 aus dem ersten Gehäuseteil 151 aus. Die Lichtwellenleiter 20 weisen eine nicht dargestellte gemeinsame Ummantelung auf. Gemäß Fig. 2 teilt sich das Bündel 150 Lichtwellenleiter 20 vor Eintritt ins Gehäuseteil 152 zu drei Bündel mit je vier Lichtwellenleitern 20 auf. Die Lichtwellenleiter 20 können sich aber auch erst nach Eintritt in das Gehäuseteil 152 aufteilen.

In dem zweiten Gehäuseteil 152 sind drei Solarmodule 12 angeordnet. Die Solarmodule 12 sind jeweils im Wesentlichen wie das in Fig. 1 gezeigte Solarmodule 12 ausgebildet. Diese weisen jeweils eine Vielzahl von Solarzellen 14 und oberseitig eine Oberfläche 16 auf. Die Solarmodule 12 sind als Stapelung 150 übereinander angeordnet. Über den Oberflächen 16 ist jeweils eine perforierte Abdeckscheibe 130 angeordnet. Den Solarmodulen 12 nachgeschaltet ist eine Batterie 170.

Die perforierten Abdeckscheiben 130 weisen gemäß Fig. 2 jeweils vier nicht näher dargestellte Durchgangsöffnungen auf, die jeweils wie die Durchgangsöffnung 32 gemäß Fig. 1 ausgebildet ist. Die Abdeckscheiben 130 können aber eine Vielzahl von Durchgangsöffnungen aufweisen, je nachdem wie viele Lichtwellenleiter angeordnet werden sollen. Die perforierten Abdeckscheiben 130 weisen jeweils unterseitig einen Reflektor 34 auf, der als Anstrich hergestellt wurde.

In den Durchgangsöffnungen 32 ist jeweils ein zweites Ende 26 eines Lichtwellenleiters 20 angeordnet, wobei die zweiten Stirnseiten 28 unterseitig in Richtung derjeweiligen Solarmodule 12 weg ragen. Die Durchgangsöffnungen 32 sind orthogonal zu den Oberflächen 16 derjeweiligen Solarmodule 12 ausgebildet. Die zweiten Stirnseiten 28 sind jeweils orthogonal zu nichtgezeigten Längsmittelachsen der zweiten Enden 26 ausgebildet. Die zweiten Stirnseiten 28 sind auch jeweils plan ausgebildet und parallel zur Oberfläche 16 des jeweiligen Solarmoduls 12 ausgerichtet. Durch diese Anordnung trifft von den zweiten Stirnseiten 28 abgegebenes Sonnenlicht direkt auf die Oberfläche 16 des jeweiligen Solarmoduls 12 auf. Hierdurch wird eine besonders effiziente Sonnenlichtübertragung auf die Solarmodule 12 ermöglicht.

Beim Betrieb des Solargenerators 100 zur Erzeugung elektrischer Energie ist die Abdeckung 140 zur Sonne 2 ausgerichtet. Sonnenlicht 4 gelangt über die Abdeckung 140 zu den ersten Stirnseiten 24. Das von den ersten Stirnseiten 24 der Lichtwellenleiter 20 aufgenommene Sonnenlicht 4 wird durch die Lichtwellenleiter 20 zu den drei Solarmodulen 12 geleitet und auf die Solarmodule 12 verteilt. Das Sonnenlicht 4 wird hierfür durch die zweiten Stirnseiten 28 in Richtung derjeweiligen Oberfläche 16 der Solarmodulen 12 abgegeben, siehe auch Fig. 1. In den Solarmodule 12 wird das Sonnenlicht durch die Solarzellen 14 zu elektrischer Energie umgewandelt, der in die nachgeschaltete Batterie 170 eingespeist wird. Die gespeicherte elektrische Energie kann als Strom genutzt werden.

Mittels der Erfindung Solargeneratoren werden mit Solarmodulen bereitgestellt, die vor Witterung geschützt sind. Die Solurmodule können in einem Gehäuse beziehungsweise Gebäude angeordnet werden. Die Wartung ist daher weniger aufwendig. Die Solarmodule müssen auch nicht flächig zur Sonne ausgerichtet werden, sondern können bei den erfindungsgemäßen Solargeneratoren beispielsweise auch übereinander kompakt als Stapelung angeordnet werden. Die Sonnenlichteinspeisung erfolgt erfindungsgemäß durch Lichtwellenleiter, wobei durch die erfindungsgemäße Anordnung der Lichtwellenleiter das Sonnenlicht besonders effizient an die Solarmodule abgegeben wird. Denn die Enden der Lichtwellenleiter sind direkt auf die jeweiligen Oberflächen der Solarmodule ausgerichtet.

## Patentansprüche

1. Solargenerator (10, 100) umfassend eine Anzahl von Solarmodulen (12) und eine Anzahl von Lichtwellenleitern (20), wobei jedes Solarmodul (12) mindestens eine Solarzelle (14) und mindestens eine Oberfläche (16) zur Aufnahme von Sonnenlicht (4) aufweist, wobei jeder Lichtwellenleiter (20) mindestens ein erstes Ende (22) mit einer ersten Stirnseite (24) zur Aufnahme von Sonnenlicht (4) und mindestens ein zweites Ende (26) mit einer zweiten Stirnseite (28) zur Abgabe von Sonnenlicht (4) aufweist, wobei an jeder Oberfläche (16) der Anzahl von Solarmodulen (12) mindestens eine zweite Stirnseite (28) der Anzahl von Lichtwellenleitern (20) derart vor oder an der jeweiligen Oberfläche (16) angeordnet ist, dass durch die mindestens eine zweite Stirnseite (28) abgegebenes Sonnenlicht (4) zumindest teilweise auf die jeweilige Oberfläche (16) trifft, **dadurch gekennzeichnet, dass** der Solargenerator (10, 100) zumindest eine perforierte Abdeckscheibe (30, 130) mit mindestens einer Durchgangsöffnung (32) umfasst und mindestens ein zweites Ende (26) der Anzahl von Lichtwellenleitern (20) zumindest teilweise in der Durchgangsöffnung (32) angeordnet ist, wobei an der Abdeckscheibe (30, 130) des Solargenerators (10, 100) mindestens ein Reflektor (34) an einer einem Solarmodul zugewandten Oberfläche der Abdeckscheibe (30, 130) angeordnet ist und mehrere Solarmodule (12) als mindestens eine Stapelung (150) angeordnet sind.

2. Solargenerator (10, 100) gemäß Anspruch 1, **dadurch gekennzeichnet, dass** die mindestens eine zweite Stirnseite (28) im Wesentlichen parallel zur jeweiligen Oberfläche (16) angeordnet ist.

3. Solargenerator (10, 100) gemäß Anspruch 1 oder 2, **dadurch gekennzeichnet, dass** die mindestens eine zweite Stirnseite (28) im Wesentlichen orthogonal zu einer Längsmittelachse (x) des jeweiligen zweiten Endes (26) des Lichtwellenleiters (20) ausgebildet ist.

4. Solargenerator (10, 100) gemäß Anspruch 1 oder 2, **dadurch gekennzeichnet, dass** die mindestens eine zweite Stirnseite (28) in einem schrägen Winkel zu einer Längsmittelachse (x) des jeweiligen zweiten Endes (26) des Lichtwellenleiters (20) ausgebildet ist.

5. Solargenerator (10, 100) gemäß einem oder mehreren der vorhergehenden Ansprüche, **dadurch gekennzeichnet, dass** mindestens eine erste Stirnseite (24) und/oder mindestens eine zweite Stirnseite (28) der Anzahl von Lichtwellenleitern (20) plan ausgebildet sind.

6. Solargenerator (10, 100) gemäß einem oder mehreren der vorhergehenden Ansprüche 1 bis 4, **dadurch gekennzeichnet, dass** mindestens eine erste Stirnseite (24) und/oder mindestens eine zweite Stirnseite (28) der Anzahl von Lichtwellenleitern (20) konvex ausgebildet sind.

7. Solargenerator (10, 100) gemäß einem oder mehreren der vorhergehenden Ansprüche, **dadurch gekennzeichnet, dass** der Solargenerator (10, 100) mindestens eine Abdeckung (40, 140) für mindestens ein erstes Ende (22) der Anzahl von Lichtwellenleitern (20) aufweist, wobei die Abdeckung (40, 140) mindestens eine Linse (42, 142) zur Lichtbündelung aufweist.

8. Solargenerator (10, 100) gemäß einem oder mehreren der vorhergehenden Ansprüche, **dadurch gekennzeichnet, dass** der Solargenerator (10, 100) zumindest ein Mittel zur Ausrichtung zur Sonne (2) für mindestens ein erstes Ende (22) der Anzahl von Lichtwellenleitern (20) umfasst.

9. Solargenerator (10, 100) gemäß einem oder mehreren der vorhergehenden Ansprüche, **dadurch gekennzeichnet, dass** mehrere Lichtwellenleiter (20) zumindest teilweise als mindestens ein Bündel (160) angeordnet sind.

10. Verwendung eines Solargenerators (10, 100) gemäß einem oder mehreren der vorhergehenden Ansprüche zur Erzeugung elektrischer Energie aus Sonnenlicht (4), **dadurch gekennzeichnet, dass** der Solargenerator (10, 100) eine Vielzahl von Solarmodulen (12) und/oder Lichtwellenleitern (20) umfasst.

## Claims

1. A solar generator (10, 100) comprising a plurality of solar modules (12) and a plurality of optical waveguides (20), wherein each solar module (12) has at least one solar cell (14) and at least one surface (16) for receiving sunlight (4), wherein each optical waveguide (20) has at least one first end (22) having a first end face (24) for receiving sunlight (4) and at least one second end (26) having a second end face (28) for giving off sunlight (4), wherein on each surface (16) of the plurality of solar modules (12) at least one second end face (28) of the plurality of optical waveguides (20) is arranged in front of or on the corresponding surface (16) in such a way that the sunlight (4) given off by the at least one second end face (28) impinges at least partially on the corresponding surface (16), **characterised in that** the solar generator (10, 100) comprises at least one perforated cover plate (30, 130) with at least one passage opening (32), and wherein at least one second end (26) of the plurality of optical waveguides (20) is at least partially arranged in the passage opening (32), wherein on the cover plate (30,130) of the solar generator (10, 100) at least one reflector (34) is arranged on a surface facing a solar module of the cover plate (30, 130) and several solar modules (12) are arranged as at least one stack (150).

2. The solar generator (10, 100) according to claim 1, **characterised in that** the at least one second end face (28) is essentially arranged in parallel to the corresponding surface (16).

3. The solar generator (10, 100) according to claim 1 or 2, **characterised in that** the at least one second end face (28) is essentially designed orthogonally to a longitudinal centre line (x) of the corresponding second end (26) of the optical waveguide (20).

4. The solar generator (10, 100) according to claim 1 or 2, **characterised in that** the at least one second end face (28) is designed at an oblique angle to a longitudinal centre line (x) of the corresponding second end (26) of the optical waveguide (20).

5. The solar generator (10, 100) according to one or more of the preceding claims, **characterised in that** at least one first end face (24) and/or at least one second end face (28) of the plurality of optical waveguides (20) are designed in a flat manner.

6. The solar generator (10, 100) according to one or more of the preceding claims 1 to 4, **characterised in that** at least one first end face (24) and/or at least one second end face (28) of the plurality of optical waveguides (20) are designed in a convex manner.

7. The solar generator (10, 100) according to one or more of the preceding claims, **characterised in that** the solar generator (10, 100) has at least one cover (40, 140) for at least one first end (22) of the plurality of optical waveguides (20), wherein the cover (40, 140) has at least one lens (42, 142) for focussing light.

8. The solar generator (10, 100) according to one or more of the preceding claims, **characterised in that** the solar generator (10, 100) comprises at least one means for orientation towards the sun (2) for at least one first end (22) of the plurality of optical waveguides (20).

9. The solar generator (10, 100) according to one or more of the preceding claims, **characterised in that** several optical waveguides (20) are at least partially arranged as at least one bundle (160).

10. Use of a solar generator (10, 100) according to one or more of the preceding claims for generating electrical energy from sunlight (4), **characterised in that** the solar generator (10, 100) comprises a plurality of solar modules (12) and/or optical waveguides (20).

## Revendications

1. Générateur solaire (10, 100) comprenant un nombre de modules solaires (12) et un nombre de fibres optiques (20), chaque module solaire (12) ayant au moins une cellule photovoltaïque (14) et au moins une surface (16) pour recevoir la lumière solaire (4), chaque fibre optique (20) ayant au moins une première extrémité (22) avec une première face frontale (24) pour recevoir la lumière solaire (4) et au moins une deuxième extrémité (26) avec une deuxième face frontale (28) pour émettre la lumière solaire (4), au moins une deuxième face frontale (28) dudit nombre de fibres optiques (20) étant disposée sur chaque surface (16) dudit nombre de modules solaires (12) devant ou sur ladite surface respective (16) de telle sorte, que ladite lumière solaire (4) émise par ladite au moins une deuxième face frontal (28) atteint au moins partiellement ladite surface respective (16), **caractérisé en ce que** ledit générateur solaire (10, 100) comprend au moins une plaque de recouvrement perforée (30, 130) avec au moins une ouverture de passage (32) et au moins une deuxième extrémité (26) dudit nombre de fibres optiques (20) est disposée au moins partiellement dans ladite ouverture de passage (32), au moins un réflecteur (34) sur ladite plaque de recouvrement (30, 130) du générateur solaire (10, 100) étant disposé sur une surface de ladite plaque de recouvrement (30, 130) tournée vers un module solaire et plusieurs modules solaires (12) étant disposés sous forme d'au moins un empilement (150).

2. Générateur solaire (10, 100) selon la revendication 1, **caractérisé en ce que** ladite au moins une deuxième face frontale (28) est disposée essentiellement parallèlement à ladite surface respective (16).

3. Générateur solaire (10, 100) selon la revendication 1 ou 2, **caractérisé en ce que** ladite au moins une deuxième face frontale (28) est formée sensiblement orthogonalement à un axe médian longitudinal (x) de ladite deuxième extrémité respective (26) de ladite fibre optique (20).

4. Générateur solaire (10, 100) selon la revendication 1 ou 2, **caractérisé en ce que** ladite au moins une deuxième face frontale (28) est formée selon un angle oblique par rapport à un axe médian longitudinal (x) de ladite deuxième extrémité respective (26) de fibre optique (20).

5. Générateur solaire (10, 100) selon une ou plusieurs des revendications précédentes, **caractérisé en ce qu'**au moins une première face frontale (24) et/ou au moins une deuxième face frontale (28) dudit nombre de fibres optiques (20) sont formées de manière plane.

6. Générateur solaire (10, 100) selon une ou plusieurs des revendications précédentes 1 à 4, **caractérisé en ce qu'**au moins une première face frontale (24) et/ou au moins une deuxième face frontale (28) dudit nombre de fibres optiques (20) sont formées de manière convexe.

7. Générateur solaire (10, 100) selon l'une ou plusieurs des revendications précédentes, **caractérisé en ce que** ledit générateur solaire (10, 100) a au moins un couvercle (40, 140) pour au moins une première extrémité (22) dudit nombre de fibres optiques (20), ledit couvercle (40, 140) ayant au moins une lentille (42, 142) pour concentrer la lumière.

8. Générateur solaire (10, 100) selon une ou plusieurs des revendications précédentes, **caractérisé en ce que** ledit générateur solaire (10, 100) comprend au moins un moyen d'orientation (2) vers le soleil pour au moins une première extrémité (22) dudit nombre de fibres optiques (20).

9. Générateur solaire (10, 100) selon une ou plusieurs des revendications précédentes, **caractérisé en ce que** plusieurs fibres optiques (20) sont au moins partiellement disposées sous la forme d'au moins un faisceau (160).

10. Utilisation d'un générateur solaire (10, 100) selon une ou plusieurs des revendications précédentes pour produire de l'énergie électrique à partir de la lumière solaire (4), **caractérisée en ce que** ledit générateur solaire (10, 100) comprend une pluralité de modules solaires (12) et/ou de fibres optiques (20).
